# EUROPEAN PATENT SPECIFICATION

(11) **EP 0 996 173 B1**
(45) Date of publication and mention of the grant of the patent: **30.12.2015**
(21) Application number: 99308117.3
(22) Date of filing: 14.10.1999
(51) Int. Cl.: H01L 29/20, H01L 21/02, H01L 33/18, H01L 27/15, H01L 33/32

(54) **Semiconductor structures including polycrystalline GaN layers and method of manufacturing**
Halbleiterstrukturen mit polykristallinen GaN-Schichten und Herstellungsverfahren
Structures semiconductrices comportant des couches polycristallines de GaN et procédé de fabrication

(30) Priority: 23.10.1998 US 105413 P; 07.01.1999 US 226114
(43) Date of publication of application: 26.04.2000
(73) Proprietor: Xerox Corporation, Rochester, NY 14644 (US)
(72) Inventor: Nickel, Norbert H., Zossen, 15806 (DE); Van de Walle, Christian G., Sunnyvale, California 94086 (US); Bour, David P., Cupertino, California 95014 (US); Mei, Ping, Palo Alto, California 94306 (US)
(74) Representative: Skone James, Robert Edmund

(56) References cited:
- EP-A- 0 484 922
- EP-A- 0 975 027
- WO-A-96/11498
- WO-A-96/22408
- JP-A- 10 256 577
- JP-A- 10 321 956
- PARK D ET AL: "Growth of GaN on ITO/glass substrates by RF PECVD method" JAPANESE JOURNAL OF APPLIED PHYSICS, PART 2, 1 MARCH 1998, vol. 37, no. 3A, pages L294-L296, XP002141393 ISSN: 0021-4922
- SATO Y. ET AL: "Low-temperature growth of GaN and InGaN films on glass substrates", J. CRYSTAL GROWTH, vol. 189, 1 June 1998 (1998-06-01), pages 42-46,

## Description

This invention is directed to semiconductor light-emitting devices. More particularly, this invention is directed to semiconductor light-emitting devices that include polycrystalline GaN.

Group-III nitrides include elements from group III of the periodic table, i.e., Al, Ga and In. These materials are deposited over substrates to form layered structures for optoelectronic devices. The devices can emit visible light over a wide range of wavelengths. GaN and its alloys with InN and AlN can be used in visible light-emitting devices that produce high emission efficiencies. Crystalline heterostructures of these materials are typically deposited epitaxially on single-crystal substrates by vapor phase epitaxy techniques. For example, full-color outdoor displays can be formed by combining existing red emitters and blue and green InGaN/AlGaN light-emitting diodes (LEDs).

LEDs have been produced that can emit all three primary colors (red, green, blue). These devices have potential utility for large-area displays. By mixing two or more colors, a range of intermediate colors can potentially be produced in such displays.

Single crystal group III-nitride LEDs have a high emission efficiency despite having high defect concentrations. These materials can have dislocation densities of ~ 10¹⁰ cm⁻². These extended defects apparently do not influence carrier flow and recombination in devices that are fabricated from these materials. This insensitivity is surprising in light of the known adverse effects that extended (i.e., one and two-dimensional) lattice defects, such as dislocations and stacking faults, normally have on the optoelectronic properties of semiconducting materials.

The potential use of known LEDs based on single-crystal LED materials in full-color displays is limited by the need to deposit these materials on single-crystal substrates. Known single crystal substrates including sapphire and silicon carbide have been formed only with limited areas. Accordingly, the size of displays that can be formed by depositing single crystal materials on such single-crystal substrates is limited as well. In addition, the number of suitable materials for forming single-crystal substrates for depositing group III-nitride semiconductor structures is limited.

"Growth of GaN on ITO/glass substrates by RF PECVD method", Park et al, Jpn. J. of App. Phys., 1 March 98, vol. 37, no. 3A, pages L294-L296, "Low-temperature growth of 6aN and In6aN follows on glass substrates", Sato et.al, J. of Crystal Growth, 1 June 1888, vol.189/190, pages 42-46, and JP10256577 each disclose polycrystalline group III-nitride semiconductor heterostructures in which an optical semiconductor layer is deposited on an electrode film supported by a substrate which may be formed of, *inter alia,* glass or fused quartz.

This invention provides polycrystalline group III-nitride semiconductorstructures. This invention separately provides light-emitting diodes (LEDs) and other light-emitting devices that comprise polycrystalline group III-nitride layers.

The polycrystalline group III-nitride materials include GaN and alloys of GaN with other group III-nitrides such as AlN and InN. These materials can be used in visible light-emitting devices to provide efficient light emission.

In accordance with the present invention, a semiconductor structure comprises a polycrystalline, substantially non-crystalline or amorphous substrate and at least one polycrystalline group III-nitride layer formed over the substrate; and characterised by a group III-nitridewetting layer formed, between the substrate and the at least one polycrystalline group-III nitride layer, the wetting layer being a monolayer formed on the substrate.

The wetting (nucleation) layer is deposited initially on the substrate to enhance deposition of subsequently formed layers over the substrate. The polycrystalline group III-nitridelayer can then be formed on the wetting layer.

The polycrystalline group III-nitride layer can be formed by first depositing amorphous group III-nitride material on the wetting layer, and then solid-phase crystallizing the amorphous material to form a polycrystalline group III-nitride layer. The amorphous group III-nitride layer is formed by a low temperature deposition technique on the wetting layer.

Advantageously, the semiconductor structure may further comprise other underlying layers such as buffer layers.

Light-emitting diodes according to this invention comprise a semiconductor structure as described above, wherein the at least one polycrystalline group III-nitride layer includes: a p-type polycrystalline group III-nitride layer formed over the wetting layer, an n-type polycrystalline group III-nitride layer formed over the wetting layer, and a light-emitting. layer of a suitable polycrystalline group III-nitride material deposited between the p-type and n-type polycrystalline group III-nitride layers. This active layer enhances electrical carrier recombination.

To enhance carrier confinement, the light-emitting devices can comprise one or more confinement layers which are formed on the active layer. The confinement layers can comprise a group III-nitride material.

As described above, the polycrystalline p-type and n-type group III-nitride layers and active layer can be initially formed as amorphous layers and subsequently solid-phase crystallized to form polycrystalline material. The low-temperature deposition of the amorphous layers can enhance the incorporation of indium in InGaN active layers, enabling the active layer to emit visible light at the longer wavelengths.

Alternatively, the group III-nitride layers can be formed on the wetting layer as polycrystalline layers at higher deposition temperatures. The wetting layer is initially deposited on the substrate to enhance sticking of gallium nitride to the substrate at the higher temperatures.

According to another aspect of this invention, the LEDs be used in large-area color displays. The displays can be monochromatic or multi-color displays. The displays comprise a substrate and a pixel array on the substrate. The substrates are polycrystalline, substantially non-crystalline or amorphous, and can have relatively large areas as compared to single crystal substrates. The polycrystalline group III-mtride layers deposited on the wetting layer enable enhanced structural flexibility. The pixels each comprise a light-emitting device according to this invention formed on the substrate. The light-emitting devices can emit violet or near-UV light, or alternatively visible light of a selected color.

In multi-color displays according to this invention, each pixel can emit a selected color. The pixels can comprise a red, green or blue phosphor. The phosphors can be formed either over the light-emitting devices or on the opposite surface of the substrate. The displays comprise n-electrodes (address electrode) and a plurality of separately addressable p-electrodes (control electrodes) over the light-emitting devices. The phosphors are each tuned to absorb light emitted by the light-emitting device and to re-emit light at a selected wavelength. Accordingly, the pixels can emit three different primary colors to provide a full-color, large area display.

This invention also provides a method of making the above-described semiconductor structures.

Various embodiments of this invention will be described in detail, with reference to the following figures, wherein:
Fig. 1 illustrates a comparative example of a layered semiconductor structure not forming part of this invention;
Fig. 2 illustrates a layered semiconductor structure according to this invention;
Fig. 3 illustrates a light-emitting device according to this invention;
Fig. 4 illustrates a first multi-color display according to this invention;
Fig. 5 illustrates a second multi-color display according to this invention;
Fig. 6 illustrates a third multi-color display according to this invention;
Fig. 7 is an exemplary schematic circuit diagram of one pixel in an active matrix array of the full-color displays shown in Figs. 4, 5 and 6;
Fig. 8 shows the x-ray diffraction spectrum (2θ/θ scan) of amorphous GaN deposited on a quartz substrate;
Fig. 9 shows the x-ray diffraction spectrum of laser-crystallized GaN deposited on a quartz substrate according to this invention, showing GaN (002) and (004) peaks;
Fig. 10 is a plot of luminescence versus wavelength of a light-emitting device including a polycrystalline GaN structure according to this invention;
Fig. 11 shows the x-ray diffraction spectrum of a polycrystalline InGaN light-emitting device grown on a quartz substrate according to this invention; and
Fig. 12 illustrates the emission spectrums of InGaN light-emitting devices for a single crystal LED grown epitaxially on a c-face sapphire substrate and for a polycrystalline light-emitting device deposited on a quartz substrate according to this invention.

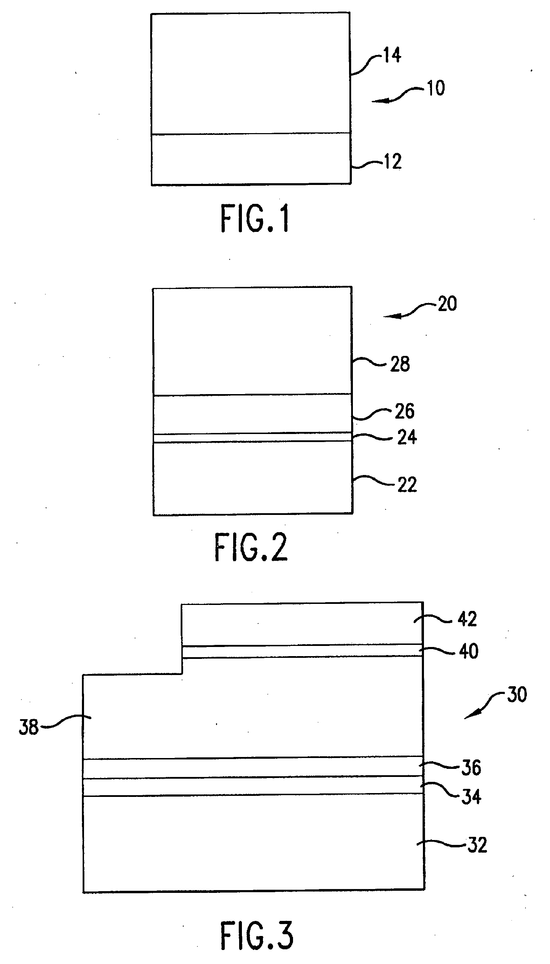

Fig. 1 illustrates a comparative example of a semiconductor structure 10 not forming part of this invention.

The semiconductor structure comprises a substrate 12 and a group III-nitride 14 layer formed over the substrate 12.

The substrate 12 can be polycrystalline, substantially non-crystalline or amorphous. For example, the substrate 12 can comprise, for example, quartz or silica glass. These materials can provide substrates of larger area than known single-crystal substrate materials such as sapphire and silicon carbide that are used as substrates for epitaxial deposition of single-crystal layered structures.

The group III-nitride layer 14 is polycrystalline. The group III-nitride layer 14 can comprise GaN, as well as ternary or quaternary alloys of GaN with AlN and InN. For example, the group III-nitride can be InₓGa₁₋ₓN. Such alloys enable the emission of light covering the entire visible spectrum depending on the value of x, and thus the In content.

The group III-nitride layer 14 can be deposited as an amorphous layer on the substrate 12. Subsequently, the amorphous layer can be treated by a suitable energy source to crystallize the amorphous layer to form a polycrystalline group III-nitride layer 14. The polycrystalline layer may be capable of light emission efficiencies that are comparable to those that have been achieved with crystalline group III-nitride structures, such as those comprising crystalline GaN and its alloys.

The amorphous group III-nitride layer 14 can be formed on the substrate 12 by a suitable deposition process. For example, amorphous group III-nitride layers can be deposited on substrates by MOCVD (metal organic chemical vapor deposition) that is typically used to grow epitaxial single-crystal material. Other known or later developed deposition methods that enable deposition of group III-nitride layers over relatively large substrate areas can also be used. For example, reactive sputtering of amorphous and microcrystalline GaN on quartz substrates has been reported in S. Nonomura et al., "Photoconductive a-GaN prepared by reactive sputtering," J. Non-Cryst. Solids 198-200 (1996) 174-177.

Amorphous group III-nitride layers can also be formed at relatively low substrate temperatures and high deposition rates. For example, MOCVD can be used to grow amorphous GaN on quartz substrates at substrate temperatures of about 500-600°C.

Suitable gas-source precursors for forming amorphous GaN (or polycrystalline GaN, as described below) include trimethyl gallium (Ga(CH₃)₃) and ammonia (NH₃). Ternary alloys can be formed by the addition of suitable gas-source precursors. For example, InGaN can be grown by the addition of trimethyl indium.

The use of low growth temperatures to form the amorphous group III-nitride layers can enhance the amount of some elements that can be incorporated into ternary alloy layers. For example, GaN can be alloyed with InN to extend the band gap of InGaN ternary alloys into the red, allowing the entire visible spectrum to be effectively covered. In a single crystal material, however, it is difficult to obtain InGaN alloys having a sufficiently high indium content using conventional deposition techniques. This is due to miscibility problems that produce segregated In-rich regions and Ga-rich regions in these layers. Low-temperature deposition of InGaN can enhance the incorporation of indium, thereby producing alloys that cover an extended portion of the visible spectrum. In addition, low-temperature deposition reduces problems associated with the high vapor pressure of InN.

The amorphous group III-nitride layer formed on the substrate can be solid-phase crystallized by laser cystallization. For example, amorphous GaN can be crystallized using suitable lasers, such as excimer lasers. Those skilled in the art will understand that the laser fluence and the number of applications of the laser beam to the amorphous materials can be varied to achieve satisfactory crystallization of amorphous group III-nitride materials.

Fig. 2 illustrates a semiconductor layered structure 20 according to this invention. In this layered structure 20, group III-nitride layers are formed over the substrate as polycrystalline layers, without initially forming amorphous layers. These polycrystalline layers can be formed at higher substrate temperatures than the temperatures that are used to form the above-described amorphous layers.

The deposition of polycrystalline GaN on silica glass substrates by molecular beam epitaxy has been demonstrated by K. Iwata et al., as reported in "Gas Source Molecular Beam Epitaxy Growth of GaN on C-, A-, R- and M-Plane Sapphire and Silica Glass Substrates," Jpn. J. Appl. Phys., Vol. 36 (1997) Pt. 2, No. 6A, pp. 661-664.

As shown in Fig. 2, to promote better coverage of the polycrystalline group III-nitride materials on the substrates, one or more intermediate layers 24, 26 are formed between the substrate 22 and the group III-nitride layer 28. The intermediate layers includes a wetting layer 24 that enhances wetting by affecting surface and interface energetics. For example, to compensate for the low sticking coefficient of gallium on quartz and other suitable polycrystalline, substantially non-crystalline or amorphous substrates, a thin film of a suitable group III-nitride material such as AIN or GaN can be initially deposited on these substrates. This thin film is deposited so that it is at most a single atom thick. That is, this thin film is a monolayer. This wetting layer 24 can cover only a portion of the substrate or can cover substantially the entire surface of the substrate surface 22. This wetting layer 24 acts as a nucleation layer and enables uniform coverage of the substrate by the overlying group III-nitride layers(s).

In addition to the thin film 24, one or more buffer layers 26 formed by a group III-nitride material, such as AlN, GaN, InGaN or AlGaN, can be deposited on the wetting layer 24. For example, a thin buffer layer 26 of amorphous GaN can be deposited on the wetting layer 24. Amorphous buffer layers can be deposited at a low temperature. The amorphous material subsequently undergoes solid-phase crystallization during a heating step prior to depositing the polycrystalline GaN. For example, the amorphous material can be crystallized by increasing the temperature in the deposition chamber to about 1050°C. Recrystallization can be conducted in a suitable atmosphere such as an NH₃-H₂ ambient atmosphere. The buffer layer typically has a thickness of from about 10-50 nm (100-500 Å).

Some embodiments of the semiconductor structure of this invention may not include the buffer layer 26. Buffer layers are typically deposited in semiconductor structures to enhance lattice matching between the substrate and the layers subsequently grown over the substrate. In this invention, however, lattice matching between the substrate and deposited layers may not be as important a consideration as in semiconductor structures comprising single crystal substrates and thin films. The buffer layer can enhance coverage of the substrate by deposited layers. Accordingly, these buffer layers can be used for this and other known purposes.

The semiconductor layered structure 20 illustrated in Fig. 2 can be used in various light-emitting devices. As described in greater detail below, the semiconductor layered structure can be used, for example, in light-emitting diodes and colored displays. Those skilled in the art will readily appreciate that other applications may be possible as well.

Fig. 3 illustrates an exemplary light-emitting diode (LED) 30 according to this invention. The LED 30 comprises a substrate 32 that can be polycrystalline, substantially non-crystalline or amorphous. A thin wetting layer 34 is grown over the substrate 32. The wetting layer 34 can comprise any suitable group III-nitride material, such as AlN, as described above. A buffer layer 36 is formed over the wetting layer 34. The buffer layer 36 can comprise any suitable group III-nitride material, such as GaN or AlN, as also described above. The buffer layer 36 can be applied as an amorphous layer and then be solid-phase crystallized at a higher temperature to form a polycrystalline layer.

After the wetting layer 34 and the buffer layer 36 are deposited on the substrate, at least one n-type (or p-type) group III-nitride layer 38 is grown over the buffer layer 36. For example, the group III-nitride layer 38 can be n-type GaN formed by the incorporation of appropriate dopants during deposition of the n-type group III-nitride layer 38. Suitable n-type dopants for GaN include Si and the like.

An active layer 40 is grown over the n-type group III-nitride layer 38. The active layer 40 enhances electron-hole recombination efficiency. The active layer 40 can comprise an alloy, such as InGaN, designed to produce visible light at a desired wavelength. For example, the alloy can have the composition In_{0.3}Ga_{0.7}N, designed to produce blue light at a desired wavelength. The composition of the active layer 40 can be varied by adjusting the proportions of In and Ga to vary the bandgap of the active layer 40, thus tuning the wavelength of light that is emitted by the LED 30. The active layer 40 can have a thickness that is sufficiently small for quantum mechanical confinement effects to be important. Active layers 40 of such small thickness are known as quantum wells. The active layer 40 typically has a thickness of from about 1-10 nm (10-100 Å).

As described in U.S. Patent Application 09/127,038, filed July 31, 1998 the indium content of the InGaN active layer 40 can be enhanced by depositing the active layer 40 on a thick InGaN layer having a thickness of between about 0.5-100 µm. This approach can decrease InGaN alloy segregation in the active region at high indium contents, enhancing the purity of spectral emission by the LED 30.

As described in U.S. Patent Application No. 09/137,112, filed August 20, 1998 ZnGeN₂ active layers can also be formed between group III-nitride layers such as GaN. ZnGeN₂ has a bandgap of about 2.7 eV, compared to a bandgap of about 3.4 eV for GaN.

A carrier confinement layer (not shown) can be formed above and/or below the active layer 40 to increase electrical carrier confinement. The confinement layer can comprise group III-V nitrides such as alloys of AlGaN.

A p-type group III-nitride layer 42 is formed over the active layer 40 (or over a carrier confinement layer in embodiments of the LED including such layer on the active layer 40). When the LED 30 includes a p-type group III-nitride layer formed below the active layer 40, an n-type group III-nitride layer is formed over the active layer 40 (or carrier confinement layer). Suitable p-type dopants for forming the layer 42 include magnesium and the like.

According to another aspect of this invention, light-emitting devices, such as the LED 30, according to this invention can be used in large area displays. This application is enabled by using polycrystalline, substantially non-crystalline or amorphous substrates in the light-emitting devices according to this invention. As stated above, these substrates can be provided in larger areas than single-crystal substrates, thereby enabling the production of larger area displays incorporating the light-emitting devices.

According to another aspect of this invention, the light-emitting devices according to this invention can be utilized in large-area monochromatic displays. Monochrome displays can emit light of a selected color dependent on the structure of the light-emitting devices according to this invention and the particular active layer that it includes.

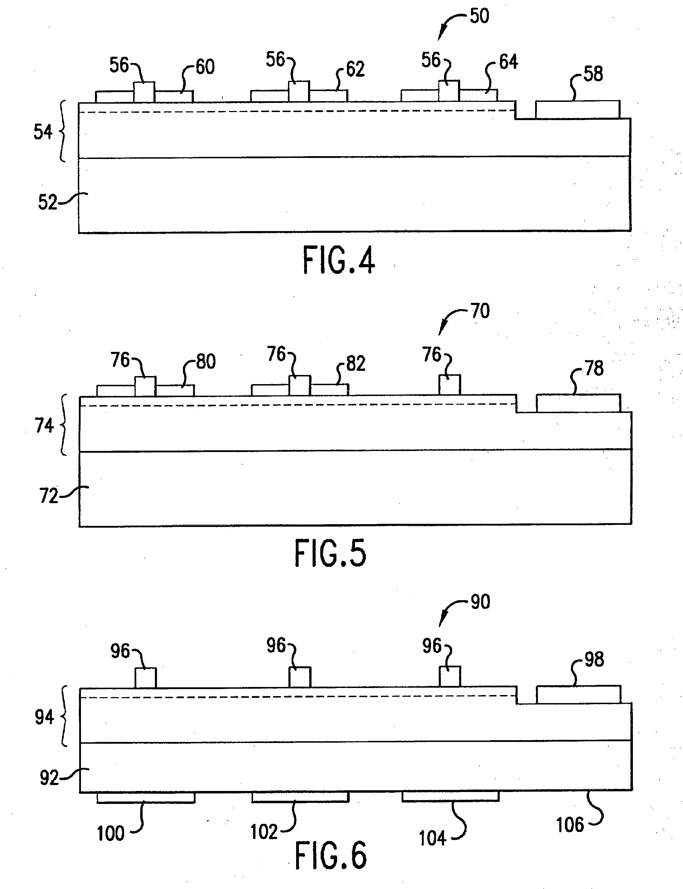

The light-emitting devices according to this invention can also be used in large-area, multi-color and full-color displays. Fig. 4 illustrates an exemplary full-color display 50 according to this invention. The display 50 can comprises a polycrystalline, substantially non-crystalline or amorphous substrate 52, such as a quartz or silica glass substrate. An array of polycrystalline light-emitting devices 54 are formed on the substrate 52. The light-emitting devices 54 according to this invention can be, for example, the LED 30 described above, and can be formed by conventional photolithography techniques known to those skilled in the art. The light-emitting devices 54 can emit light of a selected wavelength. For example, the light-emitting devices 54 can emit violet or near-ultraviolet light. The display 50 combines pixels that can each emit a selected color. As shown in Figs. 4-6, various phosphor materials 60, 62 and 64 can be deposited on the light-emitting devices 54. These phosphor materials 60, 62 and 64 can be tuned to absorb light energy of the wavelength emitted by the light-emitting devices 54 and to emit light of a selected wavelength and color. For example, the phosphors 60, 62 and 64 can be excited to emit red, green and blue light, respectively, such that the display 50 can emit all colors.

- In addition to the light-emitting devices 54, each pixel includes a separately addressable control electrode 56 associated with one of the phosphors 60, 62 and 64. The end contact may be a common electrode 58.

Fig. 5 shows another exemplary display 70 according to this invention. The display 70 comprises a substrate 72 and an array of light-emitting devices 74 according to this invention formed on the substrate. In this embodiment, the light-emitting devices 74 emit blue light directly. To enable the generation of all three primary colors, the display 70 also includes phosphors 80 and 82 that absorb blue light and re-emit red and green light, respectively. Accordingly, the display 70 can emit red, green and blue light. As shown, each pixel comprises a separately addressable control electrode 76. The display 70 also comprises a common electrode 78.

Fig. 6 shows another exemplary display 90 according to this invention. The display 90 comprises a substrate 92 and an array of light-emitting devices 94 formed on the substrate 92. Like the light-emitting devices 54, the light-emitting devices 94 emit violet or near-UV light. The substrate 92 is transparent. In contrast to the display 50, the display 90 comprises three phosphors 100, 102 and 104 formed on the bottom surface 106 of the substrate 92. The phosphors 100, 102 and 104 can emit red, green and blue light, respectively. Each pixel further comprises a separately addressable control electrode 96 over the light-emitting device 94. The display 90 also comprises a common electrode 98.

It will be understood by those skilled in the art that the colored displays according to this invention can be monochromatic displays. Such displays can comprise an array of light-emitting devices that emit light of some selected color such as blue light. Optionally, the light-emitting devices can emit violet or near-ultraviolet light and a single phosphor color (red, green or blue) can be associated with each light-emitting device.

It will also be understood by those skilled in the art that the displays can be constructed to emit two selected colors. For example, the light-emitting devices can emit a first color and a phosphor can emit a second color.

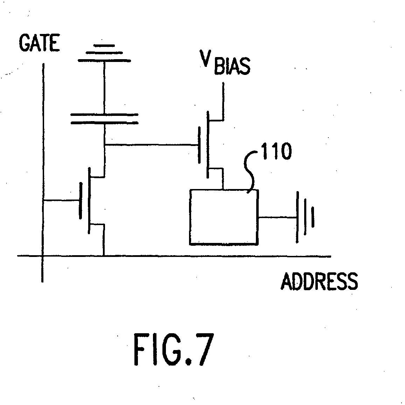

Fig. 7 illustrates a schematic circuit diagram for one pixel in an active matrix color display according to this invention. The pixel comprises a light-emitting device 110 according to this invention.

- In one exemplary embodiment of the methods for forming the light-emitting devices according to this invention, an amorphous GaN layer was deposited over a quartz substrate by MOCVD at a temperature of about 550°C. The amorphous layer was subsequently solid-phase crystallized by using an excimer laser. A single pulse with a laser fluence of 142 mJ/cm² was used during crystallization.

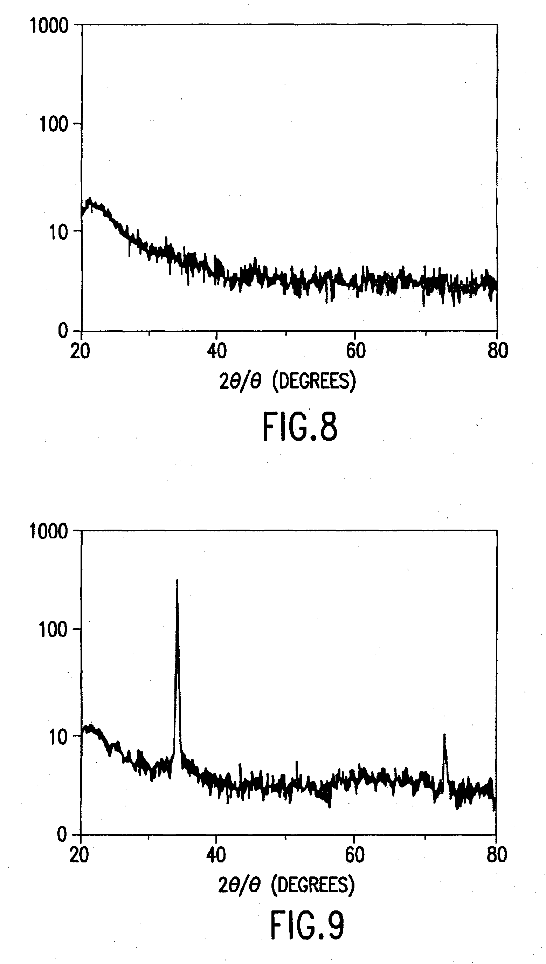

Figs. 8 and 9 show x-ray diffraction spectrums (2θ/θ scans) of amorphous GaN and laser-crystallized polycrystalline GaN, respectively, formed according to this exemplary method. Fig. 9 shows two peaks for the polycrystalline GaN material. These peaks were identified as GaN (002) and GaN (004).

These experimental results demonstrate that amorphous GaN can be crystallized using an excimer laser to form polycrystalline GaN.

In another exemplary embodiment of the methods for forming the light-emitting devices according to this invention, polycrystalline GaN was deposited directly over a quartz substrate by growth at a high temperature of 1050°C. Polycrystalline GaN film growth on quartz followed a deposition sequence including the initial formation of an AlN nucleation layer on the quartz substrate. The AlN nucleation layer was applied to compensate for the low sticking coefficient of gallium nitride on quartz. The AlN nucleation layer was applied as a thin monolayer film on a portion of the substrate. A thin amorphous GaN buffer layer was then deposited on the nucleation layer at a temperature of about 550°C. The amorphous GaN buffer layer had a thickness of about 30 nm (300 Å). The GaN buffer layer was solid-phase crystallized by increasing the temperature to about 1050°C in a NH₃:H₂ ambient atmosphere. Subsequently, thick polycrystalline GaN were deposited on the crystallized GaN buffer layer to form a layered semiconductor structure.

The structural properties of the polycrystalline GaN structure were very similar to those of the laser crystallized material. In addition, the structure displayed photoluminescence comparable to that of epitaxial GaN films grown on sapphire.

In another exemplary embodiment of the methods for forming the light-emitting devices according to this invention, a polycrystalline GaN device structure was formed by using the same technique described above. Particularly, an AlN nucleation layer and a GaN buffer layer were initially grown on a quartz substrate. Next, an LED structure was formed by growing p-type and n-type layers on the GaN buffer layer. Particularly, a Si-doped n-type GaN layer was grown at a temperature of about 1θ50°C on the GaN buffer layer. A thin In_{0.3}Ga_{0.7}N (estimated composition) single quantum well active layer was grown on the n-type GaN layer. The n-type GaN layer had a thickness of about 4 µm and the In_{0.3}Ga_{0.7}N had a thickness of about 30 Å. Finally, a Mg-doped p-type GaN layer having a thickness of about 0.2 µm was formed on the In_{0.3}Ga_{0.7}N layer.

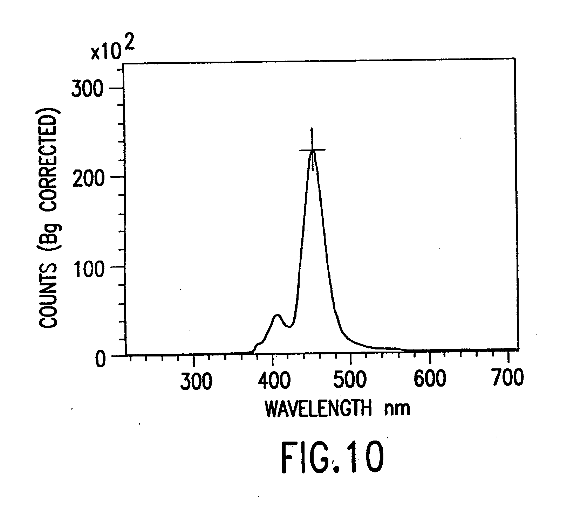

Fig. 10 shows the emitted light intensity as a function of wavelength for the polycrystalline GaN LED structure. As shown, the LED emitted blue light.

A single-crystal LED reference sample was simultaneously grown on a c-oriented sapphire substrate, for comparison of structural and performance characteristics to the polycrystalline structure.

From these materials, LEDs were fabricated by evaporating Ti/Au p-contact metal, patterning the metal into ∼500 µm dots on 1 mm centers, and argon-ion milling surrounding material. The etch depth was about 1 µm, as is typical for epitaxial LEDs grown on sapphire substrates, to expose the underlying n-type material. For LED operation, the n-type contact was made by touching a metal probe tip to the n-type GaN layer surface.

Unlike the specular surface typically obtained for single crystal LED material grown on single crystal sapphire substrates, the surface of the polycrystalline material grown over a quartz substrate was quite rough. Because of this irregular surface, the p-n junction may not have been removed uniformly by the ion milling. Furthermore, this surface morphology made the nature of the p-type GaN/metal contact ambiguous, as the relatively thin layer of p-type GaN may not have completely coated each of the crystallites.

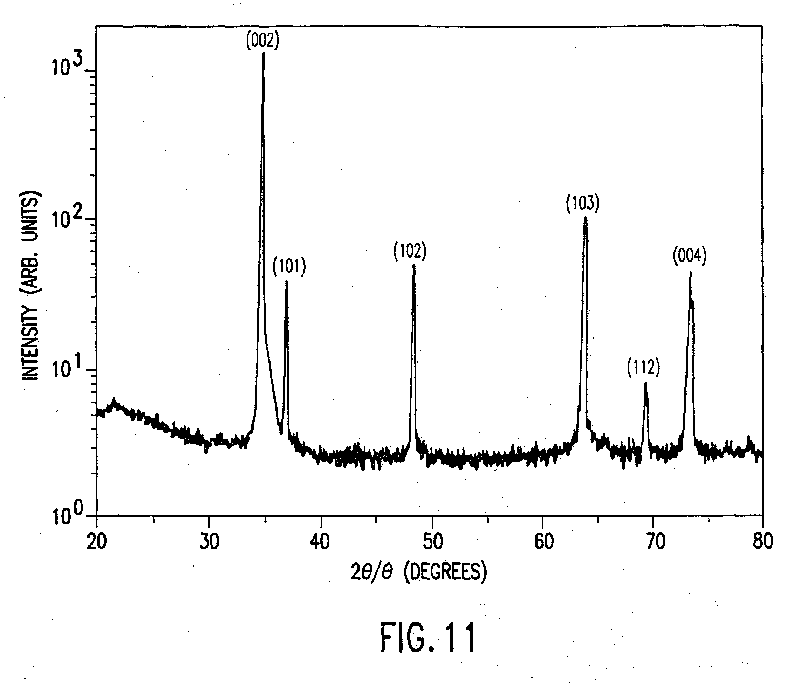

A scanning electron microscope (SEM) image of the surface showed that the typical size of the crystals was several microns, or about the same order as the film thickness. Furthermore, the presence of flat-topped, hexagon-cross section crystallites suggests that there is a tendency toward growth in a c-orientation. This preferred orientation is likewise evident in the x-ray diffraction spectrum, shown in Fig. 11, which contains a (002) reflection that is strong compared to the intensity expected for an array of randomly-oriented polycrystals.

In Table 1 below, the measured diffracted intensities are compared with tabulated values corresponding to perfectly random polycrystals (Joint Committee on Powder Diffraction Standards (JPCPDS) (1976)). In each case, the intensities are normalized to the (101) reflection, because it is expected to be the strongest reflection from a random assembly of crystallites. Table 1 shows that the (002) reflection is especially pronounced, indicating a preferred c-orientation for the group III-nitride films grown on the quartz substrate. Accordingly, the (004) reflection is also relatively strong, and several of the assymetric reflections are absent in the measured spectrum.

**TABLE 1**

| Angle (2θ) | Index | Measured I/I₍₁₀₁₎ | JCPDSI/I₍₁₀₁₎ |
|---|---|---|---|
| 32.41° | (100) | 0 | 70 |
| 34.56° | (002) | 3521 | 50 |
| 36.82° | (101) | 100 | 100 |
| 48.09° | (102) | 116 | 60 |
| 57.91° | (110) | 0 | 90 |
| 63.42° | (103) | 258 | 80 |
| 67.75° | (200) | 0 | 20 |
| 69.17° | (112) | 21 | 80 |
| 70.60° | (201) | 0 | 70 |
| 72.88° | (004) | 116 | 20 |
| 78.38° | (202) | 0 | 50 |

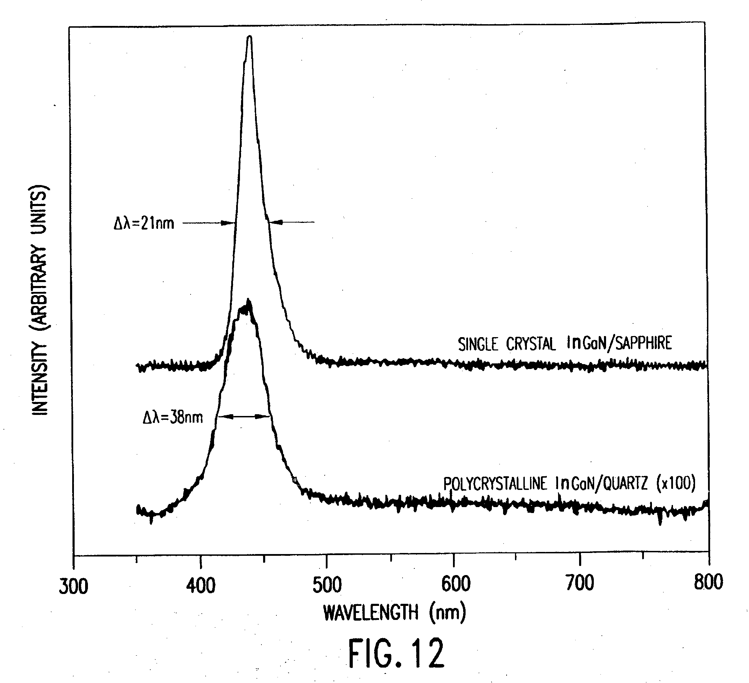

Although the orientation of the polycrystals was not completely random, the structure was still highly disordered, such that many natural growth faces were still exposed during growth of the InGaN quantum well (QW). Because the growth rate and alloy composition are influenced by the plane upon which a layer is grown, it is natural to expect a range of quantum well parameters among the polycrystals, broader than the distribution which occurs for single-crystal LEDs. Such a range of quantum well thickness and composition should translate into less spectral purity for the LED emission. This was evident in Fig. 12 , which shows a comparison of the emission collected through the substrate, of the single crystal LED (sapphire substrate) and the polycrystalline LED (quartz substrate) from the same growth run. While both spectra peak at ~ 430 nm, the spectral width of the polycrystalline LED is nearly double that of the single-crystal LED.

Compared to the single-crystal LED, the detected emission was approximately 100 times less intense for the polycrystalline device. Despite relatively weak electroluminescence from the polycrystalline LEDs, several factors may have inhibited a meaningful comparison of the emission efficiency for the two kinds of LEDs. It is believed that the non-optimized contact arrangement, along with a poorly-defined current path in the polycrystalline LEDs, may have contributed to their low efficiency. For instance, the injection path is well-confined in the single crystal LEDs, such that light is emitted only under the p-contact. In contrast, the emission pattern from the polycrystals was much more complicated, with many bright emission spots observed in the region between the two contacts. This distributed emission was not effectively collected by a fiber-coupled spectrometer, thus contributing to the apparent inefficiency indicated by Fig. 12.

Such a scattered emission pattern may not be so unusual, however, for LEDs constructed from polycrystalline material. The multitude of grain boundaries present in polycrystalline films forces the injected current to traverse a complicated path through the crystallites, in order to be injected across the junction and into the InGaN quantum well. Consequently, when viewed with a microscope, the emission contains many small, bright spots, both between and around the two contacts, corresponding to such a percolation path assumed by the diode current. Additionally, the function of the metal contacts is also questionable in this simple structure, because LED operation was observed whether the n-type contact was chosen to be one of the Ti/Au dots or a probe tip touched directly onto the etched regions.

From these emission spots between the contacts, and the lack of any substantial difference between an n-contact placed on the etched versus as-grown surfaces, it is apparent that the etching step did not completely penetrate through the p-n junction in all the crystallites.

Further optimization of the device structure, including more sophisticated etching to more uniformly remove the junction, and/or further patterning of the material to define a current injection path, may contribute to more efficient luminescence from these polycrystalline devices.

## Claims

1. A semiconductor structure (20,30,50,70,90), comprising:
a polycrystalline, non-crystalline or amorphous substrate (22,32,52,72,92); and at least one polycrystalline group III-nitride layer (28,38) formed over the substrate, (22,32,52,72,92) and **characterised by**
a group III-nitride wetting layer (24,34) formed between the substrate (22,32,52,72,92) and the at least one polycrystalline group-III nitride layer (28,38), the wetting layer (24,34) being a monolayer of group-III nitride material formed on the substrate (22,32,52,72,92).

2. The semiconductor structure of claim 1, wherein the at least one group III-nitride layer (28,38) comprises at least one GaN layer.

3. The semiconductor structure of claim 1 or 2, further comprising a group III-nitride buffer layer (26,36) formed on the wetting layer (24,34).

4. The semiconductor structure of any one of the preceding claims, further comprising at least one group III-nitride carrier confinement layer.

5. A light-emitting diode (30), comprising:
a semiconductor structure according to any one of claims 1, 2 and 4;
wherein the at least one polycrystalline group III-nitride layer includes:
a p-type polycrystalline group III-nitride layer (42) formed over the wetting layer (24,34);
an n-type polycrystalline group III-nitride layer (38) formed over the wetting layer (24, 34); and
a group III-nitride light-emitting layer (40) formed between the p-type layer (24) and the n-type layer (38).

6. A display (50), comprising:
an array of light-emitting diodes according to claim 5 formed on a substrate (52,72,92);
wherein each light-emitting diode emits light of a selected wavelength.

7. The display of claim 6, further comprising:
at least two phosphors (60,62,64,80,82,100,102,104) emitting at different wavelengths;
wherein the light-emitting diodes emit light of a wavelength effective to excite the at least two phosphors (60,62,64,80,82,100,102,104) such that the display emits at least one of blue, green and red light.

8. A method of making a semiconductor structure (20,30,50,70,90); comprising:
providing a polycrystalline, non-crystalline or amorphous substrate (22,32,52,72,92); and
forming at least one polycrystalline group III-nitride layer(28,38) over the substrate (22,32,52,72,92); and **characterised by** forming a group III-nitride wetting layer (24,34) on the substrate (22,32,52,72,92) and forming the at least one polycrystalline group III-nitride layer (28,38) over the wetting layer (24,34), the wetting layer (24,34) being a monolayer of group-III nitride material.

9. The method of claim 8, wherein the at least one polycrystalline group III-nitride layer (28,38) is formed by depositing amorphous group III-nitride material over the wetting layer (24,34), and subsequently solid-phase crystallizing the amorphous group III-nitride material to form the polycrystalline group III-nitride layer(28,38).

## Patentansprüche

1. Halbleiterstruktur (20, 30, 50, 70, 90), umfassend:
ein polykristallines, nicht kristallines oder amorphes Substrat (22, 32, 52, 72, 92); und
mindestens eine polykristalline Gruppe-III-Nitrid-Schicht (28, 38), die über dem Substrat (22, 32, 52, 72, 92) ausgebildet ist; und **gekennzeichnet durch**
eine Gruppe-III-Nitrid-Befeuchtungsschicht (24, 34), die zwischen dem Substrat (22, 32, 52, 72, 92) und der mindestens einen polykristallinen Gruppe-III-Nitrid-Schicht (28, 38) ausgebildet ist, wobei die Befeuchtungsschicht (24, 34) eine Einfachschicht aus Gruppe-III-Nitrid-Material ist, das auf dem Substrat (22, 32, 52, 72, 92) ausgebildet ist.

2. Halbleiterstruktur nach Anspruch 1, wobei die mindestens eine Gruppe-III-Nitrid-Schicht (28, 38) mindestens eine GaN-Schicht umfasst.

3. Halbleiterstruktur nach Anspruch 1 oder 2, des Weiteren umfassend eine Gruppe-III-Nitrid-Pufferschicht (26, 36), die auf der Befeuchtungsschicht (24, 34) ausgebildet ist.

4. Halbleiterstruktur nach einem der vorhergehenden Ansprüche, des Weiteren umfassend mindestens eine Gruppe-III-Nitrid-Trägerbegrenzungsschicht.

5. Lichtemittierende Diode (30), umfassend:
eine Halbleiterstruktur nach einem der Ansprüche 1, 2 und 4,
wobei die mindestens eine polykristalline Gruppe-III-Nitrid-Schicht beinhaltet:
eine polykristalline Gruppe-III-Nitrid-Schicht (42) vom p-Typ, die über der Befeuchtungsschicht (24, 34) ausgebildet ist;
eine polykristalline Gruppe-III-Nitrid-Schicht (38) vom n-Typ, die über der Befeuchtungsschicht (24, 34) ausgebildet ist; und
eine lichtemittierende Gruppe-III-Nitrid-Schicht (40), die zwischen der Schicht (42) vom p-Typ und der Schicht (38) vom n-Typ ausgebildet ist.

6. Bildschirm (50), umfassend:
eine Anordnung von lichtemittierenden Dioden nach Anspruch 5, die auf einem Substrat (52, 72, 92) ausgebildet sind;
wobei jede lichtemittierende Diode ein Licht mit einer ausgewählten Wellenlänge emittiert.

7. Bildschirm nach Anspruch 6, des Weiteren umfassend:
mindestens zwei Leuchtstoffe (60, 62, 64, 80, 82, 100, 102, 104), die auf verschiedenen Wellenlängen emittieren;
wobei die lichtemittierenden Dioden Licht mit einer Wellenlänge emittieren, das dazu wirksam ist, die mindestens zwei Leuchtstoffe (60, 62, 64, 80, 82, 100, 102, 104) zu erregen, so dass der Bildschirm mindestens eines aus blauem, grünem und rotem Licht emittiert.

8. Verfahren zum Herstellen einer Halbleiterstruktur (20, 30, 50, 70, 90), umfassend:
Bereitstellen eines polykristallinen, nicht kristallinen oder amorphen Substrats (22, 32, 52, 72, 92); und
Bilden von mindestens einer polykristallinen Gruppe-III-Nitrid-Schicht (28, 38) über dem Substrat (22, 32, 52, 72, 92), und
**gekennzeichnet durch** Bilden einer Gruppe-III-Nitrid-Befeuchtungsschicht (24, 34) auf dem Substrat (2 20, 32, 52, 72, 92) und Bilden der mindestens einen polykristallinen Gruppe-III-Nitrid-Schicht (28, 38) über der Befeuchtungsschicht (44, 34), wobei die Befeuchtungsschicht (24, 34) eine Einfachschicht aus Gruppe-III-Nitrid-Material ist.

9. Verfahren nach Anspruch 8, wobei die mindestens eine Gruppe-III-Nitrid-Schicht (28, 38) durch Aufbringen von amorphem Gruppe-III-Nitrid-Material gebildet wird, um das polykristalline Gruppe-III-Nitrid über der Befeuchtungsschicht (24, 34) auszubilden, und durch anschließendes Festphasen-Kristallisieren des amorphen Gruppe-III-Nitrid-Materials, um die polykristalline Gruppe-III-Nitrid-Schicht (28, 38) zu bilden.

## Revendications

1. Structure semi-conductrice (20, 30, 50, 70, 90), comprenant :
un substrat polycristallin, non cristallin ou amorphe (22, 32, 52, 72, 92) ; et
au moins une couche de nitrure du groupe III polycristallin (28, 38) formée sur le substrat (22, 32, 52, 72, 92), et **caractérisée par**
une couche de mouillage de nitrure du groupe III (24, 34) formée entre le substrat (22, 32, 52, 72, 92) et l'au moins une couche de nitrure du groupe III polycristallin (28, 38), la couche de mouillage (24, 34) étant une monocouche d'un matériau de nitrure du groupe III formée sur le substrat (22, 32, 52, 72, 92).

2. Structure semi-conductrice de la revendication 1, dans laquelle l'au moins une couche de nitrure du groupe III (28, 38) comprend au moins une couche de GaN.

3. Structure semi-conductrice de la revendication 1 ou 2, comprenant en outre une couche tampon de nitrure du groupe III (26, 36) formée sur la couche de mouillage (24, 34).

4. Structure semi-conductrice de l'une quelconque des revendications précédentes, comprenant en outre au moins une couche de confinement de porteurs de nitrure du groupe III.

5. Diode électroluminescente (30), comprenant :
une structure semi-conductrice selon l'une quelconque des revendications 1, 2 et 4 ;
dans laquelle l'au moins une couche de nitrure du groupe III polycristallin comporte :
une couche de nitrure du groupe III polycristallin de type p (42) formée sur la couche de mouillage (24, 34) ;
une couche de nitrure du groupe III polycristallin de type n (38) formée sur la couche de mouillage (24, 34) ; et
une couche électroluminescente de nitrure du groupe III (40) formée entre la couche de type p (42) et la couche de type n (38).

6. Dispositif d'affichage (50), comprenant :
un réseau de diodes électroluminescentes selon la revendication 5, formé sur un substrat (52, 72, 92) ;
dans lequel chaque diode électroluminescente émet de la lumière d'une longueur d'onde sélectionnée.

7. Dispositif d'affichage de la revendication 6, comprenant en outre :
au moins deux luminophores (60, 62, 64, 80, 82, 100, 102, 104) émettant à des longueurs d'onde différentes ;
dans lequel les diodes électroluminescentes émettent de la lumière d'une longueur d'onde efficace pour exciter les au moins deux luminophores (60, 62, 64, 80, 82, 100, 102, 104) de sorte que le dispositif d'affichage émette au moins l'une d'une lumière bleue, verte et rouge.

8. Procédé de fabrication d'une structure semi-conductrice (20, 30, 50, 70, 90) comprenant le fait :
de fournir un substrat polycristallin, non cristallin ou amorphe (22, 32, 52, 72, 92) ; et
de former au moins une couche de nitrure du groupe III polycristallin (28, 38) sur le substrat (22, 32, 52, 72, 92), et
**caractérisé par** la formation d'une couche de mouillage de nitrure du groupe III (24, 34) sur le substrat (22, 32, 52, 72, 92) et la formation de l'au moins une couche de nitrure du groupe III polycristallin (28, 38) sur la couche de mouillage (24, 34), la couche de mouillage (24, 34) étant une monocouche d'un matériau de nitrure du groupe III.

9. Procédé de la revendication 8, dans lequel l'au moins une couche de nitrure du groupe III polycristallin (28, 38) est formée par dépôt d'un matériau de nitrure du groupe III amorphe sur la couche de mouillage (24, 34), et ensuite par cristallisation en phase solide du matériau de nitrure du groupe III amorphe pour former la couche de nitrure du groupe III polycristallin (28, 38).
